# EUROPEAN PATENT APPLICATION

(11) **EP 2 487 791 A1**
(43) Date of publication of application: **15.08.2012**
(21) Application number: 10821698.7
(22) Date of filing: 07.09.2010
(51) Int. Cl.: H03G 7/00, H03G 11/00

(54) **MULTIBAND COMPRESSOR AND ADJUSTMENT METHOD OF SAME**

(30) Priority: 07.10.2009 JP 2009232995
(71) Applicant: NEC Corporation, Tokyo 108-8001 (JP)
(72) Inventor: HOSOKAWA, Satoshi, Tokyo 108-8001 (JP)
(74) Representative: Vossius & Partner
(86) International application number: PCT/JP2010/005482
(87) International publication number: WO 2011/043020

(57) **Abstract**

Disclosed is a multiband compressor which applies a dynamics compression process to each of a plurality of bands of an audio signal having been divided into frequency band, then applies additive synthesis, and subsequently outputs the additive synthesis result. Each power which is input or output in each of the plurality of bands is measured, and the frequency bands are set on the basis of a difference between the powers in adjacent bands. Alternatively, each power which is input in each of a plurality of bands is measured, a predetermined relative threshold is added to each value obtained by smoothing the each power, and each threshold to be given to the dynamics compression process in each of the plurality of bands is set. Therefore, a multiband compressor is provided in which an appropriate volume increase effect can be obtained regardless of what kind of signal is input.

## Description

### TECHNICAL FIELD

The present invention relates to a multiband compressor which applies a dynamics compression process to each of a plurality of bands of an audio signal having been divided into frequency bands, then applying additive synthesis, and subsequently outputs the additive synthesis result, and a method of adjusting the same.

### BACKGROUND ART

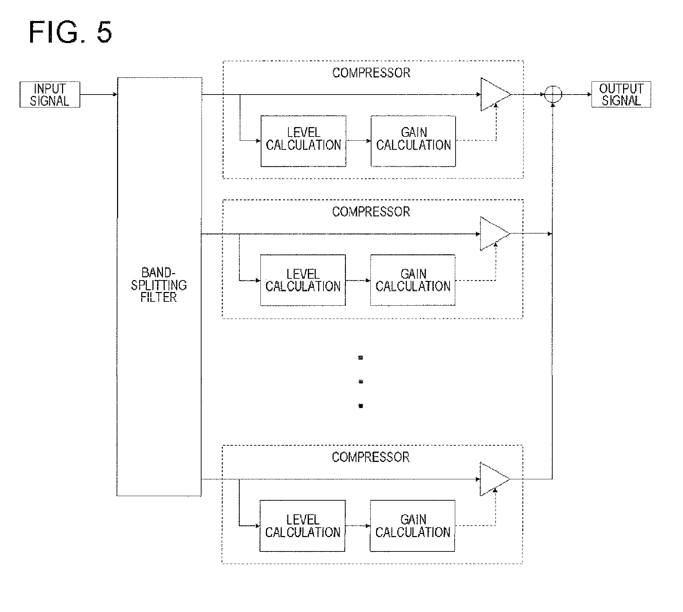

Fig. 5 illustrates the configuration of a general multiband compressor. The multiband compressor performs an audio process which divides an input audio signal into frequency bands by a band division filter (also called an isolator), performs a compressor process to each divided band, adds the divided bands, and outputs the addition result.

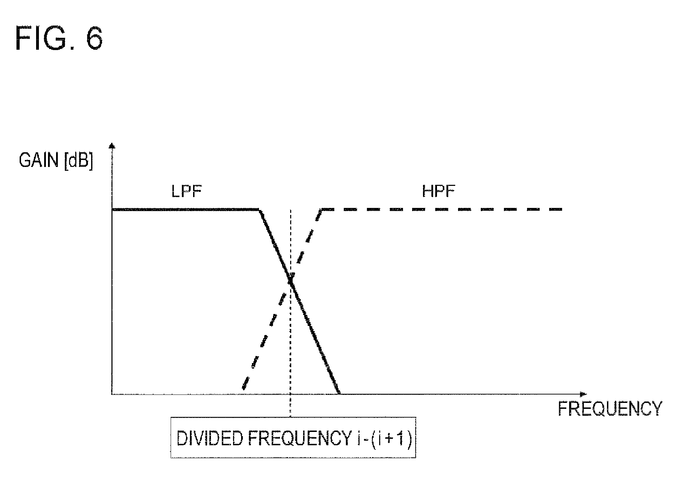

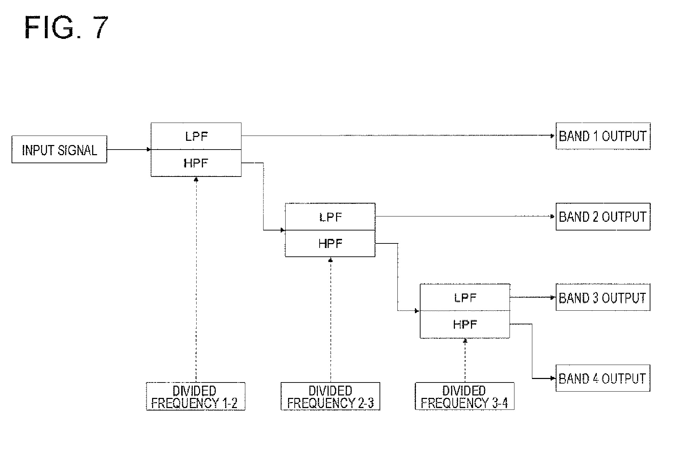

Figs. 6 and 7 illustrate a general configuration example of a band division filter. As illustrated in Fig. 7, the band division filter includes a plurality of pairs of a low-pass filter (LPF) and a high-pass filter (HPF) having the same cutoff frequency shown in Fig. 6, and is configured to isolate a signal sequentially from a low frequency band or a high frequency band (from a low frequency band in the example of the drawing). The frequency which becomes the boundary between the bands is specified from the outside.

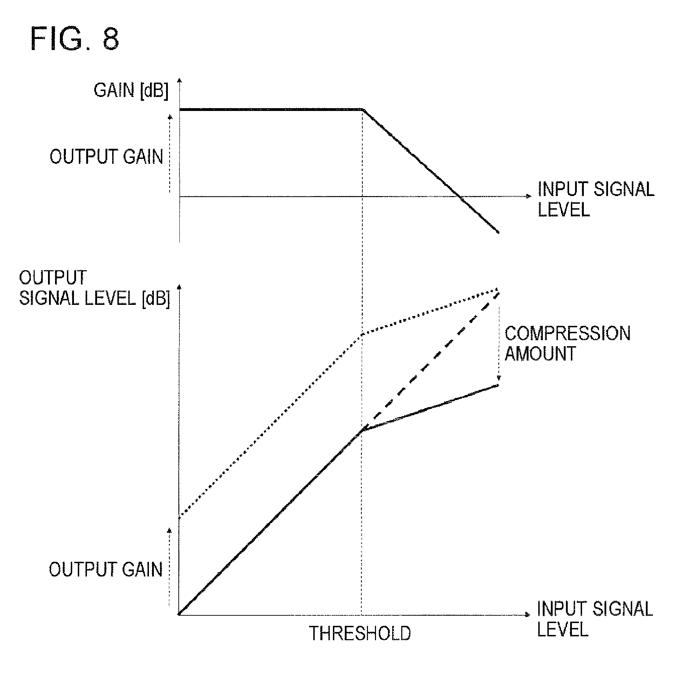

The compressor process is a function of measuring the level of the input signal, applying a volume curve illustrated in Fig. 8, and outputting the result. A boundary level, called a threshold, with respect to the input signal is given in advance, and when the input volume is equal to or greater than the threshold, the volume is turned down according to the specified compression amount.

An output gain for the amount of the volume to be turned down with respect to the maximum input is given, thereby obtaining the effect of increasing the average volume throughout the compressor. The multiband compressor performs the compressor process separately in each frequency band, and even if the volume in a certain frequency band undergoes a rapid change, the rapid change does not affect other frequency bands.

For this reason, even in a sound source (general music or the like) having a plurality of sound sources, it is possible to obtain a sufficient volume increase effect without causing unnatural audio shaking. At present, as the above-described multiband compressor, various types have been suggested (for example, see Patent Documents 1 to 4).

### RELATED DOCUMENT

### PATENT DOCUMENT

[Patent Document 1] Japanese Laid-Open Patent Publication No. 2005-160038
[Patent Document 2] Japanese Laid-Open Patent Publication No. 05-064297
[Patent Document 3] Japanese Laid-Open Patent Publication No. 09-046795
[Patent Document 4] Japanese Laid-Open Patent Publication No. 2009-507407

### DISCLOSURE OF THE INVENTION

However, adjusting the multiband compressor is extremely difficult due to the following reasons.
(1) It is necessary to adjust the compressor having a high degree of difficulty over a plurality of bands.
(2) The frequency bands and the settings of the compressor affect each other. If the frequency bands change, it is necessary to reset the settings of the compressor, and vice versa.

The invention has been finalized in consideration of the above-described problems, and an object of the invention is to provide a multiband compressor and a method of adjusting the same.

The invention provides a first multiband compressor which applies a dynamics compression process to each of a plurality of bands of an audio signal having been divided into frequency bands, then applies additive synthesis, and outputs the additive synthesis result. The multiband compressor includes a power measurement unit which measures each power input or output in each of the plurality of bands, and a band setting unit which sets the frequency bands on the basis of a difference between the power in adjacent bands.

The invention also provides a second multiband compressor which applies a dynamics compression process to each of a plurality of bands of an audio signal having been divided into frequency bands, then applies additive synthesis, and outputs the additive synthesis result. The multiband compressor includes a power measurement unit which measures each power input in each of the plurality of bands, a threshold addition unit which adds a predetermined relative threshold to each value obtained by smoothing the each power, and a threshold setting unit which sets each threshold to be given to the dynamics compression process in each of the plurality of bands.

The invention also provides a first method of adjusting a multiband compressor which applies a dynamics compression process to each of a plurality of bands of an audio signal having been divided into frequency bands, then applies additive synthesis, and outputs the additive synthesis result. The method includes setting the frequency bands such that power distributed to the each band becomes equal.

The invention also provides a second method of adjusting a multiband compressor which applies a dynamics compression process to each of a plurality of bands of an audio signal having been divided into frequency bands, then applies additive synthesis, and outputs the additive synthesis result. The method includes setting the dynamics compression process such that power distributed to the each band becomes equal.

One of the parameters which affect each other when adjusting the multiband compressor can be fixed, and the degree of freedom for adjustment can become smaller, thereby distinctly facilitating adjustment. An average signal is subjected to adjustment together, thereby obtaining an appropriate volume increase effect regardless of what kind of signal is input.

### BRIEF DESCRIPTION OF THE DRAWINGS

The above objects and other objects, features, and advantages will be more apparent from the following preferred embodiments in conjunction with the accompanying drawings.

Fig. 1 is a characteristic diagram illustrating a frequency and a signal level of an adjustment method according to a first embodiment of the invention.
Fig. 2 is a characteristic diagram illustrating a frequency and an average level obtained from several music contents.
Fig. 3 is a block diagram illustrating a multiband compressor of a first example.
Fig. 4 is a block diagram illustrating a multiband compressor of a second example.
Fig. 5 is a block diagram illustrating a multiband compressor of the related art.
Fig. 6 is a characteristic diagram illustrating a frequency and a gain of the multiband compressor of the related art.
Fig. 7 is a schematic view illustrating a band division filter of the multiband compressor of the related art.
Fig. 8 is a characteristic diagram illustrating a threshold and a signal level of the multiband compressor of the related art.

### DESCRIPTION OF EMBODIMENTS

An embodiment of the invention will be hereinafter described with reference to the drawings. The invention provides an adjustment method which facilitates parameter adjustment and obtains an optimum volume increase effect in a multiband compressor which applies a dynamics compression process (compressor) to each of a plurality of bands of an audio signal having been divided into frequency bands, then applies additive synthesis, and subsequently outputs the additive synthesis result. The invention also provides a multiband compressor which automatically executes the adjustment method.

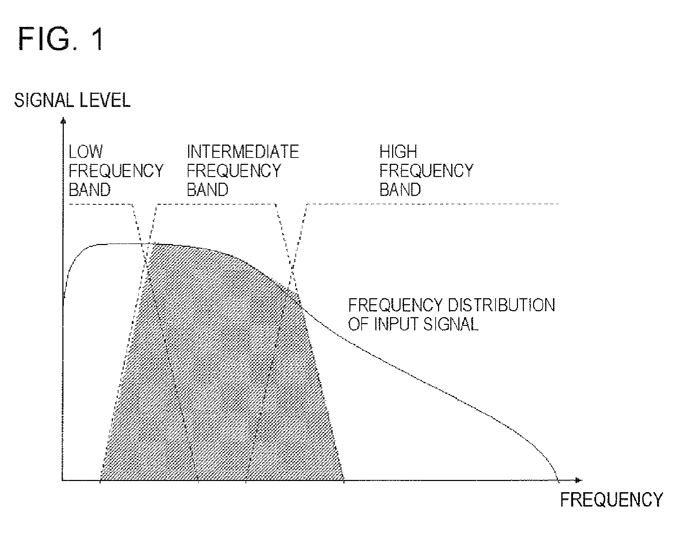

Fig. 1 is a characteristic diagram illustrating the basic concept of an embodiment of the invention. Fig. 1 illustrates an example where a multiband compressor divides an input signal into three bands. The multiband compressor, divides an input signal into a plurality of bands.

Meanwhile, since the characteristics (indicated by dotted lines in the drawing) of a filter which is used for division are determined at the time of design of the multiband compressor, when a signal with a known frequency-power distribution is given, power which is distributed to each band can be predicted.

That is, if power of an input signal with respect to a frequency f is S (f), and the gain of a band i at the frequency f is G(f), power Pi which is postulated to be input in the band i is expressed by the following expression.

Pi=int_0^Fs/2 S(f)G(f)df
Fs is a sampling frequency, and int is an integral symbol.

In general, when an apparatus, such as a music player or a mobile phone, is produced, the frequency-power distribution of an input signal differs moment to moment. However, if there is a certain degree of assumption, the average frequency-power distribution to be postulated can be predicted.

For example, when it is assumed that a general music content is used, the frequency-power distribution which gives a person a pleasant feeling is known, and many music contents have a similar distribution.

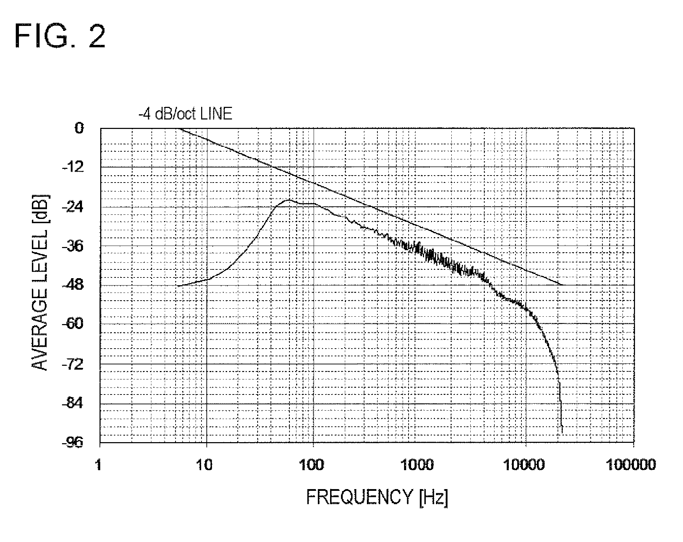

Fig. 2 illustrates an average frequency-power distribution obtained from several music contents. As illustrated in the drawing, the distribution becomes -4 dB/oct except that the volume is turned down near 20 Hz and 20000 Hz as audibility.

An audio signal which is used for a call or the like also has the same distribution. In the adjustment method of this embodiment, it is possible to the set values of the multiband compressor in advance by one of the following methods.

### [First Adjustment Method] Power Equal Division Method

In this adjustment method, on the assumption that there is a limit to the volume increase effect which is obtained by one compressor, a compressor in each band has a comparable job.

When a signal with an average distribution is input, the frequency bands are set such that power input in each band becomes equal. Each compressor has the same setting, or at least the same threshold is used.

### [Second Adjustment Method] Relative Threshold Fixing Method

In this adjustment method, the compression amount of each band becomes equal such that the frequency-power distribution does not significantly change before and after the process.

The frequency bands are freely set by audibility evaluation or the like. Subsequently, power when a signal with an average distribution is input is calculated by the above-described expression, and a value obtained by adding a negative fixed value (for example, -6 dB) to power is set as a threshold.

In either the first adjustment method or the second adjustment method, one of the parameters which affect each other when adjusting the multiband compressor can be fixed, and the degree of freedom for adjustment can become smaller, thereby distinctly facilitating adjustment. An average signal is subjected to adjustment together, thereby obtaining an appropriate volume increase effect regardless of what kind of signal is input.

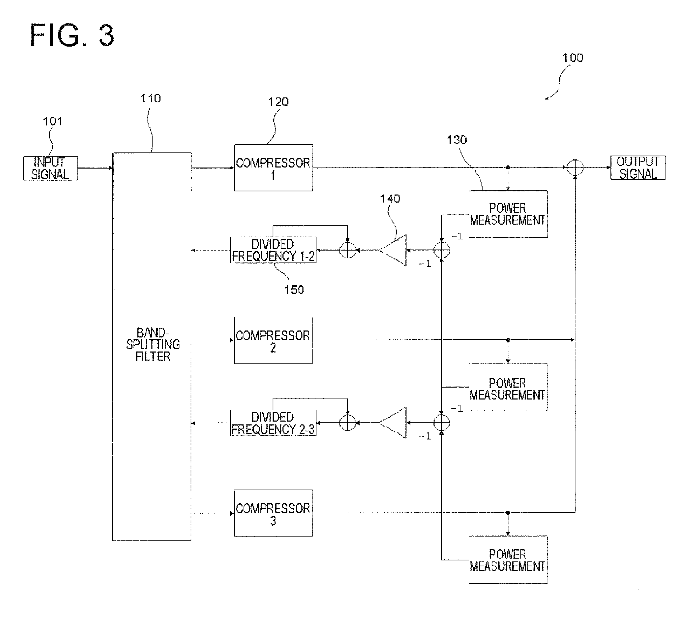

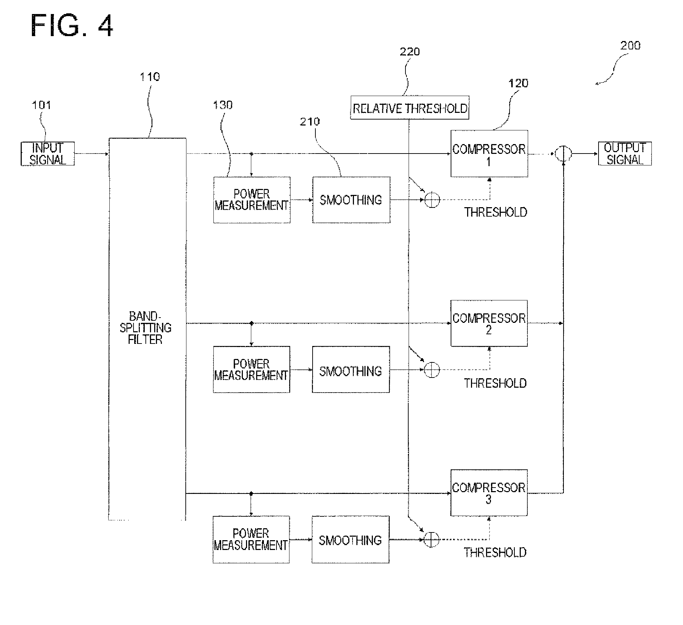

Figs. 3 and 4 illustrate an example where the multiband compressor is configured to automatically execute each of the first adjustment method and the second adjustment method of a first example (in the drawings, a band 1 is a low-frequency side and a band 3 is a high-frequency side).

In Fig. 3, a power measurement unit is arranged to measure the signal, level of a compressor output (or input) in each band. A mechanism is added to compare the measurement result of each band with the measurement result of an adjacent band and to feed back the comparison result to the frequency bands.

Specifically, in a multiband compressor 100, a plurality of compressors 120 are connected to a band division filter 110 to which an input signal 101 is input. A power measurement unit 130 is connected for each output of the plurality of compressors 120.

A comparator 140 is connected to each pair of adjacent power measurement units of the plurality of power measurement units 130. The comparator 140 is connected to the band division filter 110 through a divided frequency regulator 150 in a feedback manner.

In this configuration, when power in a certain band is excessive, since feedback occurs sandwiching the frequency range of the corresponding band, resulting in the optimum result of the power equal-division method based on the input signal.

In Fig. 4, a power measurement unit is added to measure the signal level of a compressor input in each band, and after smoothing in the time direction, a relative threshold (negative fixed value, for example, -6 dB) which has been given in advance is added to set the threshold of the compressor.

Specifically, in a multiband compressor 200, a plurality of compressors 120 are connected to a band division filter 110 to which an input signal 101 is input. A power measurement unit 130 is connected to each input of the plurality of compressors 120.

The smoothing circuit 210 is connected to each of the plurality of power measurement units 130. The power measurement unit 130 and the smoothing circuit 210 are connected to the compressor 120 along with a relative threshold 220 in a feedback manner.

In this configuration, the threshold is automatically adjusted on the basis of the average power over a given range of the input signal, resulting in the optimum result of the relative threshold fixing method based on the input signal.

In these examples, adjustment is automatically performed from an input signal without using a signal with an average distribution. For this reason, even when a signal which is significantly shifted from the average is input, it is possible to automatically correct the set values, thereby obtaining a maximum volume increase effect.

The invention is not limited to this embodiment, and various modifications may be made without departing from the scope and spirit of the invention. This application claims priority based on Japanese Patent Application No. 2009-232995, filed on October 7, 2009, the entire disclosure of which is incorporated herein by reference.

## Claims

1. A multiband compressor which applies a dynamics compression process to each of a plurality of bands of an audio signal having been divided into frequency bands, then applies additive synthesis, and outputs the additive synthesis result, the multiband compressor comprising:
a power measurement unit which measures each power input or output in each of the plurality of bands; and
a band setting unit which sets the frequency bands on the basis of a difference between the powers in adjacent bands.

2. A multiband compressor which applies a dynamics compression process to each of a plurality of bands of an audio signal having been divided into frequency bands, then applies additive synthesis, and outputs the additive synthesis result, the multiband compressor comprising:
a power measurement unit which measures each power input in each of the plurality of bands;
a threshold addition unit which adds a predetermined relative threshold to each value obtained by smoothing the each power; and
a threshold setting unit which sets each threshold to be given to the dynamics compression process in each of the plurality of bands.

3. A method of adjusting a multiband compressor which applies a dynamics compression process to each of a plurality of bands of an audio signal having been divided into frequency bands, then applies additive synthesis, and outputs the additive synthesis result, the method comprising:
setting the frequency bands such that power distributed to the each band becomes equal.

4. A method of adjusting a multiband compressor which applies a dynamics compression process to each of a plurality of bands of an audio signal having been divided into frequency bands, then applies additive synthesis, and outputs the additive synthesis result, the method comprising:
setting the dynamics compression process such that power distributed to the each band becomes equal.

5. The method according to claim 3,
wherein each power distributed to each of the plurality of bands is calculated, and
the frequency bands are set such that a compression amount becomes equal between the plurality of bands.

6. The method according to claim 4,
wherein each power distributed to each of the plurality of bands is calculated, and
the dynamics compression process is set such that a compression amount becomes equal between the plurality of bands.

7. The method according to claim 5,
wherein each power input or output in each of the plurality of bands is measured, and
the frequency bands are set on the basis of a difference between the powers in adjacent bands.

8. The method according to claim 6,
wherein each power input or output in each of the plurality of bands is measured, and
the dynamics compression process is set on the basis of a difference between the powers in adjacent bands.

9. The method according to claim 8,
wherein each power input in each of the plurality of bands is measured,
a predetermined relative threshold is added to each value obtained by smoothing the each power, and
each threshold to be given to the dynamics compression process in each of the plurality of bands is set.
